(19) **Europäisches Patentamt / European Patent Office / Office européen des brevets**

(11) **EP 3 382 709 B1**

(12) **FASCICULE DE BREVET EUROPEEN**

(45) Date de publication et mention
de la délivrance du brevet:
**18.11.2020 Bulletin 2020/47**

(51) Int Cl.:
*G11C 5/02* *(2006.01)* *G11C 11/412* *(2006.01)*
*G11C 11/417* *(2006.01)* *H01L 27/06* *(2006.01)*
*H01L 27/11* *(2006.01)*

(21) Numéro de dépôt: **18164392.5**

(22) Date de dépôt: **27.03.2018**

(54) **CELLULE MÉMOIRE SRAM**

SRAM-SPEICHERZELLE

SRAM MEMORY CELL

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **27.03.2017 FR 1752529**

(43) Date de publication de la demande:
**03.10.2018 Bulletin 2018/40**

(73) Titulaire: **Commissariat à l'Energie Atomique et
aux Energies
Alternatives
75015 Paris (FR)**

(72) Inventeurs:
• **NOEL, Jean-Philippe
38330 MONTBONNOT SAINT MARTIN (FR)**
• **AKYEL, Kaya Can
38000 GRENOBLE (FR)**
• **GIRAUD, Bastien
38340 VOREPPE (FR)**

(74) Mandataire: **Cabinet Beaumont
4, Place Robert Schuman
B.P. 1529
38025 Grenoble Cedex 1 (FR)**

(56) Documents cités:
**EP-A1- 2 131 397** **WO-A1-2014/185085**
**WO-A1-2014/209278** **JP-A- H04 170 069**
**US-A1- 2015 102 419**

EP 3 382 709 B1

**Description**

<u>Domaine</u>

La présente demande concerne les mémoires, et notamment les mémoires vives statiques à accès aléatoires également appelées mémoires SRAM (sigle anglais pour Static Random Access Memory).

<u>Exposé de l'art antérieur</u>

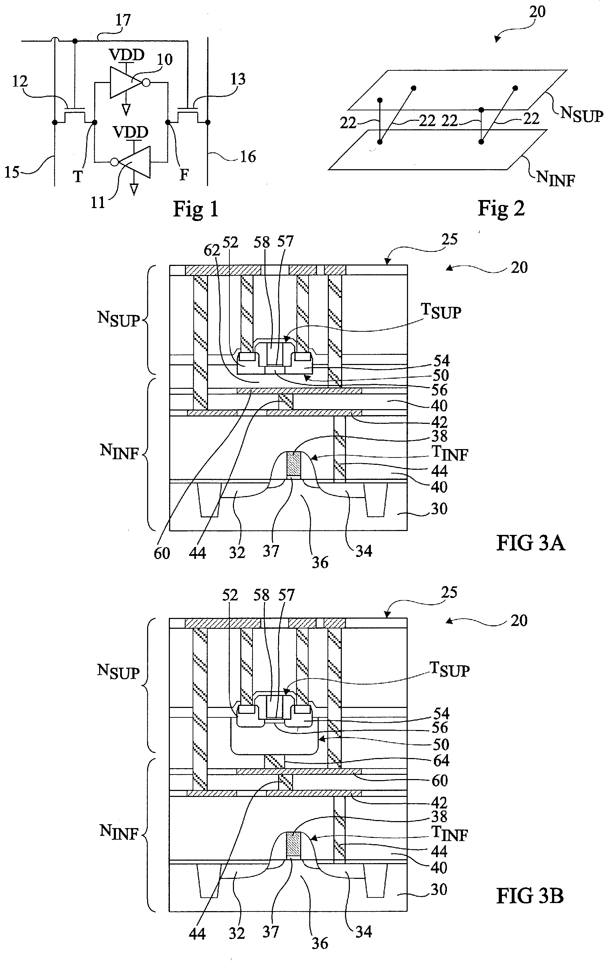

La figure 1 représente une cellule mémoire SRAM classique comprenant deux inverseurs 10, 11, connectés selon une configuration dite de bascule ou flip-flop, et deux transistors d'accès 12, 13 connectés à des lignes de bit 15 et 16, et commandés par une ligne de mot 17.
Les caractéristiques recherchées pour une cellule mémoire sont :

- une bonne stabilité en lecture également appelée SNM (SNM pour Static Noise Margin) ;
- une marge en écriture également appelée WM (WM pour Write Margin) suffisante ;
- une bonne stabilité en rétention RNM (RNM pour Rétention Noise Margin) ;
- un courant de conduction, au travers des transistors d'accès 12, 13, le plus important possible pour donner à la cellule une vitesse de fonctionnement élevée ;
- une taille de cellule la plus faible possible pour permettre de réaliser une mémoire avec une densité d'intégration de cellules importante ;
- un courant en rétention le plus faible possible afin de minimiser la puissance statique consommée.

Ces critères ne pouvant être tous satisfaits, les concepteurs de mémoires sont amenés à faire des compromis entre eux. En particulier, les cellules SRAMs sont généralement optimisées au moment de leur conception en fonction de l'application visée.
Il est connu de prévoir des circuits d'assistance pour atteindre les caractéristiques souhaitées pour une cellule mémoire. Toutefois, ceci se traduit par l'ajout de circuits supplémentaires dans la mémoire, ce qui peut entraîner un surcoût en surface et en consommation électrique non négligeable.
Le document WO2014/185085 A1 décrit une cellule mémoire SRAM comprenant deux niveaux de transistors.
Il se pose le problème de trouver une nouvelle structure de cellule mémoire SRAM présentant d'une part une bonne stabilité en rétention, en lecture et en écriture, tout en conservant un encombrement réduit et une vitesse suffisante.

<u>Résumé</u>

Un objet d'un mode de réalisation est de pallier tout ou partie des inconvénients des mémoires SRAM décrites précédemment.
Un autre objet d'un mode de réalisation est que la mémoire SRAM proposée comprend des circuits d'assistance sensiblement sans surcoût en termes de surface.
Un autre objet d'un mode de réalisation est que la cellule mémoire SRAM présente une stabilité en rétention augmentée.
Un autre objet d'un mode de réalisation est que la cellule mémoire SRAM présente une stabilité en lecture augmentée.
Un autre objet d'un mode de réalisation est que la cellule mémoire SRAM présente une stabilité en écriture augmentée.
Un autre objet d'un mode de réalisation est que la cellule mémoire SRAM présente un encombrement réduit.
Un autre objet d'un mode de réalisation est que la tension d'alimentation minimale de la cellule mémoire SRAM est diminuée.
Ainsi, un mode de réalisation prévoit une cellule de mémoire vive statique à accès aléatoire, comprenant dans un empilement de couches, des transistors dont au moins des premier et deuxième transistors d'accès connectés à une ligne de mot, le premier transistor d'accès reliant une première ligne de bit et un premier noeud de stockage et le deuxième transistor d'accès reliant une deuxième ligne de bit et un deuxième noeud de stockage, et une bascule comprenant un premier transistor de conduction reliant le premier noeud de stockage à une source d'un premier potentiel de référence et dont la grille est reliée au deuxième noeud de stockage et un deuxième transistor de conduction reliant le deuxième noeud de stockage à la source du premier potentiel de référence et dont la grille est reliée au premier noeud de stockage, les transistors se répartissant en une première pluralité de transistors situés à un premier niveau de l'empilement et une deuxième pluralité de transistors situés à au moins un deuxième niveau de l'empilement, la cellule mémoire comprenant une portion conductrice électriquement du deuxième niveau connectée à un élément choisi parmi le premier noeud de stockage, le deuxième noeud de stockage, la première ligne de bit et la deuxième ligne de bit et située en regard d'une zone de canal d'un transistor de la première pluralité de transistors et séparée de ladite zone de canal par l'intermédiaire d'une zone isolante prévue ou connectée électriquement à une portion semiconductrice contenant ladite zone de canal pour permettre un couplage entre la portion conductrice électriquement et ladite zone de canal.

Selon un mode de réalisation, la portion conductrice électriquement est connectée à l'un du premier noeud de stockage ou du deuxième noeud de stockage.

Selon un mode de réalisation, la bascule comprend en outre un troisième transistor de conduction reliant le premier noeud de stockage à une source d'un deuxième potentiel de référence et dont la grille est reliée au deuxième noeud de stockage et un quatrième transistor de conduction reliant le deuxième noeud de stockage à la source du deuxième potentiel de référence et dont la grille est reliée au premier noeud de stockage.

Selon un mode de réalisation, les premier et deuxième transistors d'accès et les premier et deuxième transistors de conduction sont situés dans le deuxième niveau. Les troisième et quatrième transistors de conduction sont situés dans le premier niveau. La zone de canal du troisième transistor de conduction est couplée au deuxième noeud de stockage et la zone de canal du quatrième transistor de conduction est couplée au premier noeud de stockage.

Selon un mode de réalisation, les premier et deuxième transistors d'accès sont situés dans le premier niveau. Les premier et deuxième transistors de conduction sont situés dans le deuxième niveau. La zone de canal du premier transistor d'accès est couplée au deuxième noeud de stockage et la zone de canal du deuxième transistor d'accès est couplée au premier noeud de stockage.

Selon un mode de réalisation, la cellule comprend en outre un circuit de lecture comprenant des premier et deuxième transistors de lecture, le premier noeud de stockage étant connecté à la grille du deuxième transistor de lecture, le premier transistor de lecture reliant le deuxième transistor de lecture à une première ligne de bit de lecture, la grille du deuxième transistor de lecture étant connectée à une deuxième ligne de bit de lecture. Les premier et deuxième transistors de lecture sont situés dans le premier niveau. Les premier et deuxième transistors d'accès et les premier et deuxième transistors de conduction sont situés dans le deuxième niveau. La zone de canal du premier transistor de lecture est couplée au premier noeud de stockage et la zone de canal du deuxième transistor de lecture est couplée au premier noeud de stockage.

Selon un mode de réalisation, la portion conductrice électriquement est connectée à l'une de la première ligne de bit ou de la deuxième ligne de bit.

Selon un mode de réalisation, les premier et deuxième transistors d'accès sont situés dans le deuxième niveau. Les premier et deuxième transistors de conduction sont situés dans le premier niveau. La zone de canal du premier transistor de conduction est couplée à la deuxième ligne de bit et la zone de canal du deuxième transistor de conduction est couplée à la première ligne de bit.

Selon un mode de réalisation, les troisième et quatrième transistors de conduction sont situés dans le deuxième niveau.

Un mode de réalisation prévoit également une mémoire comprenant des cellules telles que définies précédemment, dont des premières cellules réparties dans une première partie de l'empilement et des deuxièmes cellules réparties dans une deuxième partie de l'empilement, les premières cellules formant au moins une colonne, la mémoire comportant une première piste conductrice électriquement s'étendant le long de la colonne et formant la première ligne de bit de chaque première cellule et une seconde piste conductrice électriquement s'étendant le long de la colonne et formant la deuxième ligne de bit de chaque première cellule, la mémoire comportant, en outre, des éléments d'interconnexion s'étendant au travers des couches de l'empilement et reliant chaque deuxième cellule mémoire aux première et deuxième pistes.

Selon un mode de réalisation, les première et deuxième pistes sont en un premier matériau. Les éléments d'interconnexion sont en un deuxième matériau moins bon conducteur électrique que le premier matériau.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1, décrite précédemment, est un schéma électrique d'un exemple de cellule SRAM ;
la figure 2 est un schéma illustrant un mode de réalisation d'une cellule mémoire SRAM sur deux niveaux ;
les figures 3A et 3B sont des vues en coupe, partielles et schématiques, de modes de réalisation de la cellule mémoire SRAM de la figure 2 ;
la figure 4 est un schéma électrique général d'une cellule mémoire SRAM à six transistors ;
la figure 5 illustre un mode de réalisation d'une cellule mémoire SRAM à six transistors dont les transistors sont répartis sur deux niveaux ;
les figures 6 et 7 illustrent des modes de réalisation de cellules mémoire SRAM à quatre transistors dont les transistors sont répartis sur deux niveaux ;

la figure 8 illustre un mode de réalisation d'une cellule mémoire SRAM à huit transistors dont les transistors sont répartis sur deux niveaux ;

la figure 9 illustre un mode de réalisation d'une cellule mémoire d'une mémoire adressable par contenu dont les transistors sont répartis sur deux niveaux ;

la figure 10 illustre un mode de réalisation d'une cellule mémoire SRAM à six transistors dont les transistors sont répartis sur deux niveaux ;

les figures 11 et 12 illustrent des modes de réalisation de cellules mémoire SRAM à quatre transistors dont les transistors sont répartis sur deux niveaux ;

la figure 13 est un schéma illustrant un mode de réalisation d'un circuit électronique formé sur plusieurs niveaux ;

la figure 14 est un schéma d'une mémoire SRAM réalisée sur un seul niveau ;

les figures 15 et 16 sont des schémas illustrant un mode de réalisation d'une mémoire SRAM sur deux niveaux ;

la figure 17 illustre un mode de réalisation d'une cellule mémoire SRAM à six transistors dont les transistors sont répartis sur deux niveaux ;

la figure 18 illustre un mode de réalisation d'une cellule mémoire d'une mémoire adressable par contenu dont les transistors sont répartis sur deux niveaux ;

la figure 19 est un schéma analogue à la figure 15 illustrant un autre mode de réalisation d'une mémoire SRAM sur deux niveaux ; et

la figure 20 est une vue en perspective, partielle et schématique, d'un mode de réalisation de la cellule mémoire SRAM de la figure 7.

## Description détaillée

De mêmes éléments ont été désignés par de mêmes références dans les différentes figures. Par souci de clarté, seuls les éléments utiles à la compréhension des modes de réalisation décrits ont été représentés et sont détaillés. Sauf précision contraire, les expressions "approximativement", "sensiblement", et "de l'ordre de" signifient à 10 % près, de préférence à 5 % près.

La figure 2 représente de façon très schématique un mode de réalisation d'une cellule de mémoire vive statique à accès aléatoire 20 améliorée comprenant des transistors, notamment des transistors à effet de champ à grille isolée plus couramment nommé MOSFET (acronyme anglais de Metal Oxide Semiconductor Field Effect) réalisés dans un empilement d'un circuit électronique sur deux niveaux de l'empilement. En particulier, la cellule mémoire comprend des transistors situés dans un niveau supérieur $N_{SUP}$ qui ont une tension de seuil modulable, le canal de chacun de ces transistors étant couplé électriquement à un noeud du circuit électronique d'un niveau inférieur $N_{INF}$ par l'intermédiaire de vias conducteurs électriquement 22. Une telle structure apporte des avantages notamment en termes d'encombrement, et la possibilité de modifier de manière dynamique la tension de seuil de certains des transistors afin d'améliorer leurs caractéristiques électriques telles que la stabilité et/ou la consommation.

Les figures 3A et 3B sont des vues en coupe, partielles et schématiques, de modes de réalisation de la cellule SRAM 20, comprenant un empilement 25 de couches. Pour chacun de ces modes de réalisation, les couches de l'empilement 25 se répartissent en couches du niveau inférieur $N_{INF}$ et couches du niveau supérieur $N_{SUP}$. La couche à la base de l'empilement est appelée substrat 30. Le substrat 30 peut être un substrat massif ou de type semiconducteur sur isolant, par exemple de type silicium sur isolant ou SOI (sigle anglais pour Silicon On Insulator), comportant une première couche de support qui peut être semiconductrice et par exemple à base de Si, recouverte par une couche isolante, par exemple à base de $SiO_2$, elle-même recouverte par une couche semiconductrice, par exemple à base de Si, et dans laquelle une ou plusieurs zones actives sont susceptibles d'être formées.

Un premier transistor $T_{INF}$ est formé dans et sur le substrat 30. Le premier transistor $T_{INF}$ comporte une région de source 32, une région de drain 34, ainsi qu'une zone de canal 36, reliant la région de source 32 et la région de drain 34. Le premier transistor $T_{INF}$ peut être éventuellement formé sur un substrat SOI totalement déserté ou partiellement déserté. Le transistor $T_{INF}$ comporte également une grille 38 située sur une couche de matériau diélectrique 37 de grille 38.

Il est également prévu dans le niveau inférieur $N_{INF}$ une succession de couches isolantes 40, des pistes conductrices électriquement 42 formées entre les couches isolantes électriquement 40 et des vias conducteurs électriquement 44 au travers des couches isolantes.

La cellule SRAM 20 comporte également au moins un deuxième transistor $T_{SUP}$ dans un niveau $N_{SUP}$ de l'empilement supérieur à celui du niveau $N_{INF}$ dans lequel se trouve le premier transistor $T_{INF}$. Le deuxième transistor $T_{SUP}$ comporte, dans une portion semiconductrice 50, une région de source 52, une région de drain 54, ainsi qu'une structure de canal 56, reliant la région de source 52 et la région de drain 54. Le deuxième transistor $T_{SUP}$ comporte également une grille 58 reposant sur une couche de diélectrique 57 de grille.

Dans le mode de réalisation représenté sur la figure 3A, le deuxième transistor $T_{SUP}$ est formé selon une technologie du type substrat sur isolant complètement déplété ou FDSOI (sigle anglais pour Fully Depleted Substrate On Insulator). Dans ce mode de réalisation, la structure de canal 56 est située au-dessus d'une piste conductrice électriquement, de préférence une piste métallique 60 du dernier niveau de métallisation du niveau inférieur $N_{INF}$ et séparée de la piste métallique 60 par une zone isolante électriquement 62. La zone isolante 62 est mise en oeuvre de manière à permettre un couplage entre la piste métallique 60 et le canal du deuxième transistor $T_{SUP}$ situé au-dessus. De préférence, l'épaisseur de cette zone isolante 62 est en particulier choisie bien inférieure aux épaisseurs des couches de matériaux diélectriques inter-niveaux dans les circuits électroniques selon l'art antérieur, et qui, dans ces circuits électroniques, sont prévues pour permettre d'isoler entre eux différents niveaux superposés de composants ou de lignes d'interconnexions.

La piste conductrice 60 permet ainsi de commander le potentiel de canal du transistor $T_{SUP}$ du niveau supérieur $N_{SUP}$. De préférence, pour obtenir un meilleur contrôle du potentiel de canal du deuxième transistor $T_{SUP}$, l'intégralité de la zone semiconductrice 56 de canal du deuxième transistor $T_{SUP}$ est disposée en regard de la face supérieure ou du dessus de la piste conductrice 60. La zone de canal 56 du deuxième transistor $T_{SUP}$ peut être réalisée dans une couche semi-conductrice de faible épaisseur, de manière à permettre un contrôle statique au niveau du canal d'inversion. Par faible épaisseur, on entend que la zone de canal 56 du deuxième transistor $T_{SUP}$ peut être formée dans une portion semiconductrice 50 d'épaisseur comprise par exemple entre 1 nm et 100 nm, ou par exemple entre 5 nm et 20 nm. L'épaisseur choisie pour la portion semiconductrice 50 dans laquelle est réalisé le canal 56 est prévue notamment en fonction du niveau de dopage de cette couche pour permettre un comportement totalement déplété.

Les zones de canal des transistors $T_{SUP}$ et $T_{INF}$ peuvent être formées par exemple dans du Si ou dans un autre matériau semiconducteur, par exemple tel que du Ge. La zone isolante 62, séparant la piste conductrice 60 de la portion semiconductrice 50 dans laquelle le canal 56 du transistor $T_{SUP}$ est réalisé, est prévue pour permettre un couplage significatif de la piste conductrice 60 avec le canal 56. Par couplage significatif, on entend un couplage permettant de faire varier la tension de seuil du transistor $T_{SUP}$ de niveau supérieur d'au moins 50 mV, pour une variation de la tension appliquée à la piste conductrice 60 de niveau inférieur entre 0 et Vdd ou -Vdd et +Vdd selon l'application, avec Vdd la tension d'alimentation de la mémoire SRAM. La tension Vdd peut être par exemple de l'ordre de 1 V ou de 0,5 V. Un modèle tel que celui décrit dans l'article de Lim et Fossum : IEEE Transactions on electron devices, vol. ED-30, n°10 Octobre 1983, peut être utilisé pour dimensionner la zone isolante 62 afin d'obtenir une variation de tension de seuil désirée $\Delta V_{th}$ lorsque l'on fait varier de $\Delta V$ le potentiel de polarisation de la piste conductrice 60. Un modèle selon la relation (1) suivante peut être utilisé en particulier dans le cas où le deuxième transistor $T_{SUP}$ est réalisé sur une couche totalement désertée :

$$\Delta V_{th} = \frac{\frac{\varepsilon_{sc}}{T_{sc}} \cdot \frac{\varepsilon_{ILD}}{T_{ILD}}}{\frac{\varepsilon_{ox}}{T_{ox}} \cdot \left(\frac{\varepsilon_{sc}}{T_{sc}} + \frac{\varepsilon_{ILD}}{T_{ILD}}\right)} \cdot \Delta V \qquad (1)$$

où :

-   $\Delta V_{th}$ est la variation de tension de seuil du transistor $T_{SUP}$ ;
-   $\varepsilon_{sc}$ et $T_{sc}$ sont respectivement la permittivité diélectrique et l'épaisseur de la portion semiconductrice 50 dans laquelle le canal 56 du transistor $T_{SUP}$ est réalisé ;
-   $\varepsilon_{ox}$ et $T_{ox}$ sont respectivement la permittivité diélectrique et l'épaisseur du diélectrique 57 de grille du deuxième transistor $T_{SUP}$ ; et
-   $\varepsilon_{ILD}$ et $T_{ILD}$ sont respectivement la permittivité diélectrique et l'épaisseur du diélectrique de la zone isolante 62 séparant la portion semiconductrice 50 du deuxième transistor $T_{SUP}$ de la piste conductrice 60.

On obtient, lorsque le potentiel de la piste conductrice 60 varie de 0 à Vdd, la relation (2) suivante :

$$\Delta V_{th} = \frac{\frac{\varepsilon_{sc}}{T_{sc}} \cdot \frac{\varepsilon_{ILD}}{T_{ILD}}}{\frac{\varepsilon_{ox}}{T_{ox}} \cdot \left(\frac{\varepsilon_{sc}}{T_{sc}} + \frac{\varepsilon_{ILD}}{T_{ILD}}\right)} \cdot Vdd \qquad (2)$$

Pour atteindre un couplage significatif correspondant à une variation de tension de seuil $\Delta V_{th}$ égale à 50 mV, dans le cas où l'épaisseur $T_{sc}$ de la zone de canal 56 est égale à 7 nm, que cette dernière est en silicium, que l'épaisseur $T_{ox}$ de la zone de diélectrique 57 est égale à 1 nm, que cette dernière est à base de $SiO_2$, que Vdd est égal à 1 V, et que la zone isolante 62 est en $SiO_2$, la zone isolante 62 est prévue par exemple avec une épaisseur de l'ordre de 17,5 nm.

Dans le mode de réalisation représenté sur la figure 3B, le deuxième transistor $T_{SUP}$ est formé selon une technologie du type substrat sur isolant partiellement déplété ou PDSOI (sigle anglais pour Partially Depleted Substrate On Insulator). Dans ce mode de réalisation, la piste conductrice 60 peut être connectée électriquement à la portion semiconductrice 50, par exemple par un via conducteur électriquement 64 en dehors de la région de source 52, de la région de drain 54, et de la structure de canal 56. La piste conductrice 60 permet ainsi de commander le potentiel de canal du transistor $T_{SUP}$ du niveau supérieur $N_{SUP}$.

Un exemple de circuit électronique a été décrit avec deux transistors dans deux niveaux superposés. Mais la cellule mémoire 20 peut comprendre un nombre plus élevé de transistors, par exemple un nombre n (avec n un entier tel que n > 2) de transistors $T_1$, $T_2$, ..., $T_n$ superposés, chaque transistor $T_k$ d'un niveau donné $N_k$ (avec k un entier tel que 1 < k < n) comportant une zone de canal susceptible d'être couplée à une piste conductrice du niveau $N_{k-1}$ inférieur au niveau donné $N_k$, cette piste conductrice étant située en regard de ladite zone de canal, à une distance suffisamment faible pour permettre un tel couplage.

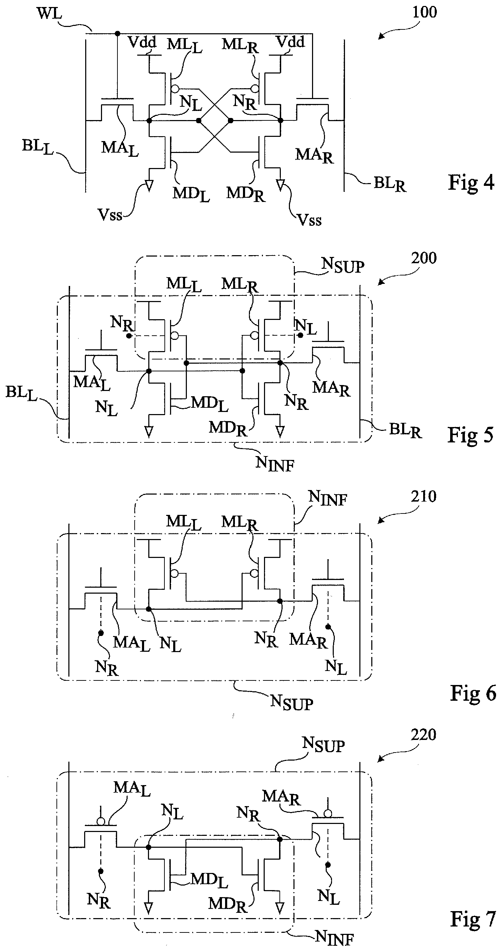

La figure 4 est un schéma électrique d'un mode de réalisation d'une cellule mémoire 100 à accès aléatoire de type 6T, c'est-à-dire dotée de 6 transistors. La cellule 100 comprend une pluralité de transistors formant un premier inverseur et un deuxième inverseur, connectés selon une configuration de bascule, communément appelée flip-flop.

Dans cet exemple, la bascule comprend un premier transistor de conduction $MD_L$ et un deuxième transistor de conduction $MD_R$, par exemple de type MOS à canal N. La grille du deuxième transistor de conduction $MD_R$ est connectée à un premier noeud de stockage $N_L$ de la cellule 100 et la grille du premier transistor de conduction $MD_L$ est connectée à un deuxième noeud de stockage $N_R$ de la cellule 100. Les sources des transistors de conduction $MD_L$, $MD_R$, sont quant à elles reliées entre elles et à une source d'un potentiel de référence bas Vss, par exemple la masse. Le drain du premier transistor de conduction $MD_L$ est relié au premier noeud $N_L$ et le drain du deuxième transistor de conduction $MD_R$ est relié au deuxième noeud $N_R$. La bascule comprend, en outre, un premier transistor de charge $ML_L$ et un deuxième transistor de charge $ML_R$, par exemple de type MOS à canal P. Les sources des transistors de charge $ML_L$, $ML_R$, sont reliées à une source d'un potentiel de référence haut Vdd et le drain du premier transistor de charge $ML_L$ est relié au premier noeud $N_L$ et le drain du deuxième transistor de charge $ML_R$ est relié au deuxième noeud $N_R$.

La cellule SRAM 100 est également dotée d'un premier transistor d'accès $MA_L$ et d'un deuxième transistor d'accès $MA_R$, par exemple des transistors MOS à canal N. Les transistors d'accès $MA_L$ et $MA_R$ comportent une grille reliée à une ligne de mot WL. La source du premier transistor d'accès $MA_L$ est reliée à une première ligne de bit $BL_L$ et la source du deuxième transistor d'accès $MA_R$ est reliée à une deuxième ligne de bit $BL_R$. Le drain du premier transistor d'accès $MA_L$ est relié au premier noeud de stockage $N_L$ et le drain du deuxième transistor d'accès $MA_R$ est relié au deuxième noeud de stockage $N_R$.

Les transistors d'accès $MA_L$, $MA_R$, sont agencés pour permettre d'accéder aux noeuds de stockage $N_L$ et $N_R$, lors d'une phase de lecture ou d'écriture de la cellule 100, et à bloquer l'accès de la cellule 100 lorsque la cellule 100 est dans un mode de rétention d'information.

Les transistors de conduction $MD_L$, $MD_R$ et de charge $ML_L$, $ML_R$ sont prévus pour maintenir une charge nécessaire à l'établissement d'un niveau logique donné, par exemple '0', correspondant par exemple à un potentiel égal au potentiel Vss, ou '1' correspondant par exemple à un potentiel égal au potentiel Vdd, sur l'un des noeuds $N_L$ ou $N_R$, en fonction de la valeur logique mémorisée dans la cellule 100.

La figure 5 illustre un mode de réalisation d'une cellule mémoire SRAM 200 à six transistors dont les transistors sont répartis sur deux niveaux $N_{INF}$ et $N_{SUP}$ et dans laquelle un procédé d'assistance en lecture est mis en oeuvre. La cellule mémoire SRAM 200 comprend l'ensemble des éléments de la cellule mémoire 100 représentée en figure 4. Les transistors MOS à canal N $MA_L$, $MA_R$, $MD_L$ et $MD_R$ sont situés dans le niveau inférieur $N_{INF}$ et les transistors MOS à canal P $ML_L$ et $ML_R$ sont situés dans le niveau supérieur $N_{SUP}$. Dans le présent mode de réalisation, la zone de canal du premier transistor de charge $ML_L$ est couplée au deuxième noeud de stockage $N_R$ et la zone de canal du deuxième transistor de charge $ML_R$ est couplée au premier noeud de stockage $N_L$, ce qui est représenté de façon schématique en figure 5 par des traits pointillés.

Du fait d'un tel agencement, la tension de seuil du premier transistor de charge $ML_L$ dépend de la donnée stockée dans le deuxième noeud de stockage $N_R$ et la tension de seuil du deuxième transistor de charge $ML_R$ dépend de la donnée stockée dans le premier noeud de stockage $N_L$. Le présent mode de réalisation permet de baisser la tension de seuil du transistor MOS à canal P servant à remonter le noeud interne de stockage vers Vdd (et donc stocker la valeur logique '1').

Un mode de fonctionnement de la cellule 200 va maintenant être décrit lors d'une opération de lecture.

Les lignes de bit $BL_L$ et $BL_R$ sont préchargées à Vdd avant l'opération de lecture. La ligne de mot WL est alors polarisée à Vdd pour accéder à la donnée mémorisée dans les noeuds de stockage $N_L$, $N_R$ via les lignes de bit $BL_L$ et $BL_R$. Les transistors d'accès $MA_L$ et $MA_R$ se trouvent alors dans un état conducteur.

Dans le cas où le premier noeud $N_L$ est à un niveau logique haut, par exemple au potentiel Vdd, et que le deuxième noeud $N_R$ est à un niveau logique bas, par exemple à 0 V, un courant de conduction s'établit entre la ligne de bit $BL_R$ et la masse Vss via le deuxième transistor de conduction $MD_R$ et le deuxième transistor d'accès $MA_R$ entraînant une décharge de la ligne de bit $BL_R$ vers la masse. Cette chute en tension sur la ligne de bit $BL_R$ entraîne une différence de tension entre les lignes de bit $BL_L$ et $BL_R$ et la détection de cette différence complète la lecture à travers un amplificateur de lecture. Toutefois, la décharge de la ligne de bit $BL_R$ vers la masse entraîne une montée en tension au deuxième noeud de stockage $N_R$. Cette montée en tension ne doit pas faire basculer l'état de la cellule. Comme le premier transistor de charge $ML_L$ est rendu davantage conducteur, ceci permet d'empêcher qu'il ne soit fermé lors de la montée de tension du deuxième noeud de stockage $N_R$. Ceci améliore la stabilité en lecture de la cellule SRAM.

La figure 6 illustre un mode de réalisation d'une cellule mémoire SRAM 210 à quatre transistors dont les transistors sont répartis sur deux niveaux $N_{INF}$ et $N_{SUP}$ et dans laquelle un procédé d'assistance en lecture et en rétention est mis en oeuvre. La cellule mémoire SRAM 210 comprend l'ensemble des éléments de la cellule mémoire 100 représentée en figure 4 à la différence que le premier transistor de conduction $MD_L$ et le deuxième transistor de conduction $MD_R$ ne sont pas présents. Les transistors MOS à canal N $MA_L$ et $MA_R$ sont situés dans le niveau supérieur $N_{SUP}$ et les transistors MOS à canal P $ML_L$ et $ML_R$ sont situés dans le niveau inférieur $N_{INF}$. Dans le présent mode de réalisation, la zone de canal du premier transistor d'accès $MA_L$ est couplée au deuxième noeud de stockage $N_R$ et la zone de canal du deuxième transistor d'accès $MA_R$ est couplée au premier noeud de stockage $N_L$.

Du fait d'un tel agencement, la tension de seuil du premier transistor d'accès $MA_L$ dépend de la donnée stockée dans le deuxième noeud de stockage $N_R$ et la tension de seuil du deuxième transistor d'accès $MA_R$ dépend de la donnée stockée dans le premier noeud de stockage $N_L$. Le présent mode de réalisation permet d'augmenter la tension de seuil du transistor d'accès connecté au noeud interne dans lequel la valeur logique '1' est stockée.

Un mode de fonctionnement de la cellule 210 va maintenant être décrit lors d'une opération de lecture. Les lignes de bit $BL_L$ et $BL_R$ sont préchargées à 0 V et les transistors d'accès $MA_L$ et $MA_R$ sont amenés dans un état conducteur. Dans le cas où le premier noeud $N_L$ est à Vdd, et que le deuxième noeud $N_R$ est à 0 V, c'est la tension de seuil du premier transistor d'accès $MA_L$ qui est augmentée, ce qui le rend moins conducteur. Le potentiel au noeud $N_L$ est alors mieux maintenu dans un état logique élevé, ce qui augmente ainsi la stabilité de l'opération de lecture.

Un mode de fonctionnement de la cellule 210 va maintenant être décrit lors d'une opération de rétention, c'est-à-dire en l'absence d'opération de lecture ou d'écriture dans la cellule. Les lignes de bit $BL_L$ et $BL_R$ sont préchargées à 0 V et les transistors d'accès $MA_L$ et $MA_R$ se trouvent alors dans un état bloqué. Dans le cas où le premier noeud $N_L$ est à Vdd, et que le deuxième noeud $N_R$ est à 0 V, c'est la tension de seuil du premier transistor d'accès $MA_L$ qui est augmentée, ce qui permet de réduire les courants de fuites traversant le premier transistor d'accès $MA_L$. La durée de rétention de la cellule mémoire 210 est alors augmentée.

La figure 7 illustre un mode de réalisation d'une cellule mémoire SRAM 220 à quatre transistors dont les transistors sont répartis sur deux niveaux $N_{INF}$ et $N_{SUP}$ et dans laquelle un procédé d'assistance en rétention et en lecture est mis en oeuvre. La cellule mémoire SRAM 220 comprend l'ensemble des éléments de la cellule mémoire 100 représentée en figure 4 à la différence que le premier transistor de charge $ML_L$ et le deuxième transistor de charge $ML_R$ ne sont pas présents, et que les transistors d'accès $MA_L$ et $MA_R$ sont des transistors MOS à canal P. Les transistors MOS à canal P $MA_L$ et $MA_R$ sont situés dans le niveau supérieur $N_{SUP}$ et les transistors MOS à canal N $MD_L$ et $MD_R$ sont situés dans le niveau inférieur $N_{INF}$. Dans le présent mode de réalisation, la zone de canal du premier transistor d'accès $MA_L$ est couplée au deuxième noeud de stockage $N_R$ et la zone de canal du deuxième transistor d'accès $MA_R$ est couplée au premier noeud de stockage $N_L$.

Du fait d'un tel agencement, la tension de seuil du premier transistor d'accès $MA_L$ dépend de la donnée stockée dans le deuxième noeud de stockage $N_R$ et la tension de seuil du deuxième transistor d'accès $MA_R$ dépend de la donnée stockée dans le premier noeud de stockage $N_L$. Le présent mode de réalisation permet d'augmenter la tension de seuil du transistor d'accès connecté au noeud interne dans lequel la valeur logique '0' est stockée.

Un mode de fonctionnement de la cellule 220 va maintenant être décrit lors d'une opération de lecture. Les lignes de bit $BL_L$ et $BL_R$ sont préchargées à Vdd et les transistors d'accès $MA_L$ et $MA_R$ sont amenés dans un état conducteur. Dans le cas où le premier noeud $N_L$ est à Vdd, et que le deuxième noeud $N_R$ est à 0 V, c'est la tension de seuil du deuxième transistor d'accès $MA_R$ de type P qui est augmentée, ce qui le rend moins conducteur. La stabilité de l'opération de lecture est ainsi améliorée car le noeud NR est mieux maintenu vers 0 V puisqu'il reçoit moins de courant provenant depuis la ligne de bit BLR.

Un mode de fonctionnement de la cellule 220 va maintenant être décrit lors d'une opération de rétention, c'est-à-dire en l'absence d'opération de lecture ou d'écriture dans la cellule. Les lignes de bit $BL_L$ et $BL_R$ sont préchargées à Vdd et les transistors d'accès $MA_L$ et $MA_R$ se trouvent alors dans un état bloqué. Dans le cas où le premier noeud $N_L$ est à Vdd, et que le deuxième noeud $N_R$ est à 0 V, c'est la tension de seuil du deuxième transistor d'accès $MA_R$ qui est augmentée, ce qui permet de réduire les courants de fuites traversant le deuxième transistor d'accès $MA_R$. La durée de rétention de la cellule mémoire 220 est alors augmentée.

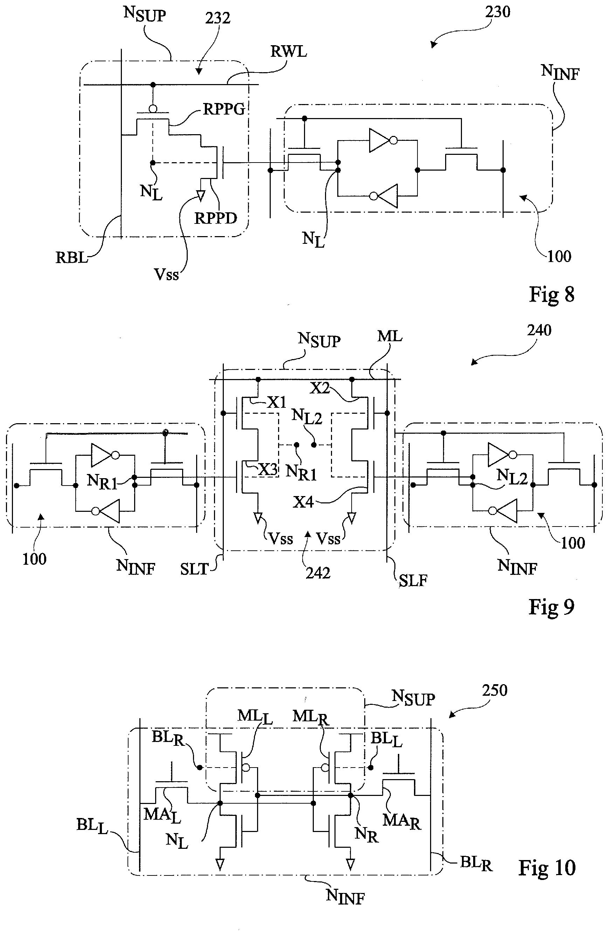

La figure 8 illustre un mode de réalisation d'une cellule mémoire SRAM 230 à huit transistors dont les transistors sont répartis sur deux niveaux et dans laquelle un procédé d'assistance en lecture est mis en oeuvre.

La cellule SRAM 8T 230 comprend la cellule mémoire 100 représentée en figure 4 et comprend, en outre, un circuit de lecture 232 comprenant deux transistors MOS RPPG et RPPD qui sont tous les deux à canal N. A titre de variante, les transistors MOS RPPG et RPPD peuvent être tous les deux à canal P. Le noeud de stockage $N_L$ de la cellule SRAM 100 est connecté à la grille du transistor RPPD. La source du transistor RPPD est connectée à la masse Vss et le drain du transistor RPPD est connecté à la source du transistor RPPG. Le drain du transistor RPPG est connecté à une ligne de bit de lecture RBL et la grille du transistor RPPG est connectée à une ligne de mot de lecture RWL. Tous les transistors MOS de la cellule mémoire SRAM 100 sont situés dans le niveau inférieur $N_{INF}$ et les transistors MOS RPPG et RPPD du circuit de lecture 232 sont situés dans le niveau supérieur $N_{SUP}$. Dans le présent mode de réalisation, la zone de canal du transistor MOS RPPG et la zone de canal du transistor RPPD sont couplées au premier noeud de stockage $N_L$. Le présent mode de réalisation permet de diminuer la tension de seuil des transistors RPPG et RPPD lorsque la valeur logique '1' est stockée dans le noeud de stockage $N_L$.

Un mode de fonctionnement de la cellule 230 va maintenant être décrit lors d'une opération de lecture. Les lignes de bit $BL_L$ et $BL_R$ sont préchargées à Vdd et les transistors d'accès $MA_L$ et $MA_R$ sont amenés dans un état conducteur. Dans le cas où le premier noeud de stockage $N_L$ est à Vdd, et que le deuxième noeud de stockage $N_R$ est à 0 V, le transistor RPPD est activé et un chemin est créé entre la ligne de bit de lecture RBL et la masse Vss. La lecture est complétée avec la détection (ou non) de la chute en tension sur la ligne de bit de lecture RBL. Les transistors RPPG et RPPD étant davantage conducteurs, ceci permet une décharge accélérée de la ligne de bit de lecture RBL dans le cas où le noeud de stockage $N_L$ stocke la valeur logique '1'. La durée d'une opération de lecture peut donc être réduite. Pour un circuit contenant une telle mémoire et dont la fréquence de fonctionnement peut être limitée par la durée d'une opération de lecture dans la mémoire, ceci permet d'augmenter la fréquence de fonctionnement du circuit.

La figure 9 illustre un mode de réalisation d'une cellule mémoire SRAM 240 d'une mémoire adressable par contenu dont les transistors sont répartis sur deux niveaux et dans laquelle un procédé d'assistance en lecture est mis en oeuvre.

La cellule SRAM 8T 240 comprend des première et deuxième cellules mémoire 100 telles que représentées en figure 4 et comprend, en outre, une porte logique OU exclusif 242, également appelée porte XOR. La porte logique 242 comprend deux transistors MOS X1 et X3 à canal N. Le deuxième noeud de stockage $N_{R1}$ de la première cellule SRAM est connecté à la grille du transistor X3. La source du transistor X3 est connectée à la masse Vss et le drain du transistor X3 est connecté à la source du transistor X1. La grille du transistor X1 est connectée à une ligne de bit de lecture SLT et le drain du transistor X1 est connecté à une ligne de mot de lecture ML. La porte logique 242 comprend, en outre, deux transistors MOS X2 et X4 à canal N. Le premier noeud de stockage $N_{L2}$ de la deuxième cellule SRAM est connecté à la grille du transistor X4. La source du transistor X4 est connectée à la masse Vss et le drain du transistor X4 est connecté à la source du transistor X2. La grille du transistor X2 est connectée à une ligne de bit de lecture SLF et le drain du transistor X2 est connecté à la ligne de mot de lecture ML. Tous les transistors MOS des première et deuxième cellules mémoire SRAM 100 sont situés dans le niveau inférieur $N_{INF}$ et les transistors MOS de la porte logique 242 sont situés dans le niveau supérieur $N_{SUP}$.

Les valeurs stockées dans les première et deuxième cellules mémoire 6T 100 déterminent la valeur stockée dans la cellule mémoire 240. A titre d'exemple, si la valeur logique '0' est stockée au deuxième noeud de stockage $N_{R1}$ de la première cellule mémoire et si la valeur logique '1' est stockée au premier noeud de stockage $N_{L2}$ de la deuxième cellule mémoire, alors on considère que la valeur logique '0' est stockée dans la cellule mémoire 240. En outre, si la valeur logique '1' est stockée au deuxième noeud de stockage $N_{R1}$ de la première cellule mémoire et si la valeur logique '0' est stockée au premier noeud de stockage $N_{L2}$ de la deuxième cellule mémoire, alors on considère que la valeur logique '1' est stockée dans la cellule mémoire 240.

La porte XOR 242 permet de faire la comparaison entre la valeur recherchée et la valeur stockée dans la cellule mémoire 240. La valeur recherchée est transmise à la cellule mémoire 240 sur la ligne de bit de lecture SLT et son complément sur la ligne de bit SLF. Une opération de lecture dans laquelle la donnée recherchée correspond à la donnée stockée dans la cellule mémoire 240 est appelée un succès (" match " en anglais) et une opération de lecture dans laquelle la donnée recherchée ne correspond pas à la donnée stockée dans la cellule mémoire 240 est appelée un échec (" miss " en anglais).

Un mode de fonctionnement de la cellule 240 va maintenant être décrit lors d'une opération de lecture. La ligne de mot de lecture ML est préchargée à Vdd. Si un échec se produit, la ligne de mot de lecture ML est déchargée via au moins l'une de deux branches de la porte XOR 242. Le temps de décharge définit la vitesse de l'opération de lecture. Le présent mode de réalisation permet de diminuer la tension de seuil des transistors X1 et X2 dans le cas d'un échec, ce qui permet de réduire la durée de l'opération de lecture.

Dans les modes de réalisation décrits précédemment dans lesquels la stabilité en lecture des cellules mémoire est améliorée, la tension d'alimentation des cellules mémoire peut être diminuée.

La figure 10 illustre un mode de réalisation d'une cellule mémoire SRAM 250 à six transistors dont les transistors sont répartis sur deux niveaux et dans laquelle un procédé d'assistance en écriture est mis en oeuvre. La cellule mémoire SRAM 250 comprend l'ensemble des éléments de la cellule mémoire 200 représentée en figure 5 à la différence que la zone de canal du premier transistor de charge $ML_L$ est couplée à la deuxième ligne de bit $BL_R$ et la zone de canal du deuxième transistor de charge $ML_R$ est couplée à la première ligne de bit $BL_L$.

Du fait d'un tel agencement, la tension de seuil du premier transistor de charge $ML_L$ dépend de la donnée présente sur la deuxième ligne de bit $BL_R$ et la tension de seuil du deuxième transistor de charge $ML_R$ dépend de la donnée présente sur la première ligne de bit $BL_L$. Le présent mode de réalisation permet d'augmenter la tension de seuil du transistor de charge connecté à la ligne de bit sur laquelle la valeur logique '0' est présente et de diminuer la tension de seuil du transistor de charge connecté à la ligne de bit sur laquelle la valeur logique '1' est présente.

Un mode de fonctionnement de la cellule 250 va maintenant être décrit lors d'une opération d'écriture. Supposons que la valeur logique '1' est stockée dans la cellule SRAM 250. Ceci signifie que la valeur logique '1' est stockée dans le premier noeud de stockage $N_L$ et que la valeur logique '0' est stockée dans le deuxième noeud de stockage $N_R$. Une opération d'écriture consiste à changer l'état du premier noeud de stockage $N_L$ de '1' à '0' et à changer l'état du deuxième noeud de stockage $N_R$ de '0' à '1'. Dans ce but, la première ligne de bit $BL_L$ est préchargée à Vss et la deuxième ligne de bit $BL_R$ est préchargée à Vdd. Les transistors d'accès $MA_L$ et $MA_R$ sont alors amenés à l'état conducteur. Un chemin de conduction est créé entre le premier noeud de stockage $N_L$ et la première ligne de bit $BL_L$ via le premier transistor d'accès $MA_L$ et un chemin de conduction est créé entre le deuxième noeud de stockage $N_R$ et la deuxième ligne de bit $BL_R$ via le deuxième transistor d'accès $MA_R$. Le premier noeud de stockage $N_L$ se décharge vers la première ligne de bit $BL_L$ et la deuxième ligne de bit $BL_R$ se décharge vers le deuxième noeud de stockage $N_R$. La tension de seuil du deuxième transistor de charge $ML_R$ étant diminuée et la tension de seuil du premier transistor de charge $ML_L$ étant augmentée, ceci facilite la fermeture du premier transistor de charge $ML_L$ lors de la montée en tension du deuxième noeud de stockage $N_R$ et le passage à l'état passant du deuxième transistor de charge $ML_R$ lors de la diminution de tension du premier noeud de stockage $N_L$. La stabilité en écriture de la cellule SRAM 250 est donc augmentée.

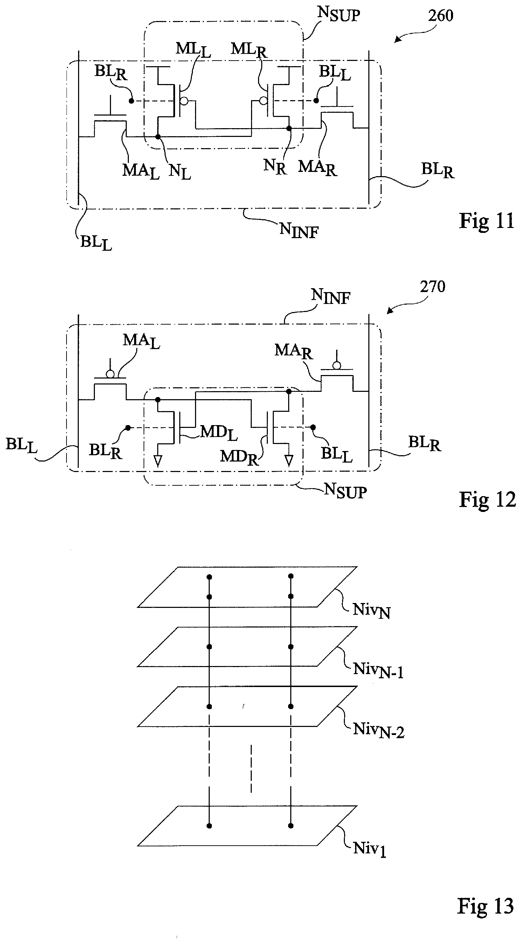

La figure 11 illustre un mode de réalisation d'une cellule mémoire SRAM 260 à quatre transistors dont les transistors sont répartis sur deux niveaux et dans laquelle un procédé d'assistance en écriture est mis en oeuvre. La cellule mémoire SRAM 260 comprend l'ensemble des éléments de la cellule mémoire 250 représentée en figure 10 à la différence que les transistors de conduction $MD_L$ et $MD_R$ ne sont pas présents. Dans le présent mode de réalisation, la zone de canal du premier transistor de charge $ML_L$ est couplée à la deuxième ligne de bit $BL_R$ et la zone de canal du deuxième transistor de charge $ML_R$ est couplée à la première ligne de bit $BL_L$. Le mode de fonctionnement de la cellule 260 est le même que ce qui a été décrit précédemment pour la cellule mémoire 250. La stabilité en écriture de la cellule SRAM 260 est augmentée.

La figure 12 illustre un mode de réalisation d'une cellule mémoire SRAM 270 à quatre transistors dont les transistors sont répartis sur deux niveaux et dans laquelle un procédé d'assistance en écriture est mis en oeuvre. La cellule mémoire SRAM 270 comprend l'ensemble des éléments de la cellule mémoire 250 représentée en figure 10 à la différence que les transistors de charge $ML_L$ et $ML_R$ ne sont pas présents, que les transistors d'accès $MA_L$ et $MA_R$ sont des transistors MOS à canal P, que les transistors MOS à canal P $MA_L$ et $MA_R$ sont situés dans le niveau inférieur $N_{INF}$ et que les transistors MOS $MD_L$ et $MD_R$ à canal N sont situés dans le niveau supérieur $N_{SUP}$. Dans le présent mode de réalisation, la zone de canal du premier transistor de conduction $MD_L$ est couplée à la deuxième ligne de bit $BL_R$ et la zone de canal du deuxième transistor de conduction $MD_R$ est couplée à la première ligne de bit $BL_L$.

Du fait d'un tel agencement, la tension de seuil du premier transistor de conduction $MD_L$ dépend de la donnée présente sur la deuxième ligne de bit $BL_R$ et la tension de seuil du deuxième transistor de conduction $MD_R$ dépend de la donnée présente sur la première ligne de bit $BL_L$. Le présent mode de réalisation permet d'augmenter la tension de seuil du transistor de conduction connecté à la ligne de bit sur laquelle la valeur logique '1' est présente et de diminuer la tension de seuil du transistor de conduction connecté à la ligne de bit sur laquelle la valeur logique '0' est présente.

Un mode de fonctionnement de la cellule 270 va maintenant être décrit lors d'une opération d'écriture. Supposons que la valeur logique '1' est initialement stockée dans la cellule SRAM 270. Ceci signifie que la valeur logique '1' est stockée dans le premier noeud de stockage $N_L$ et que la valeur logique '0' est stockée dans le deuxième noeud de stockage $N_R$. Pour une opération d'écriture, la première ligne de bit $BL_L$ est préchargée à Vss et la deuxième ligne de bit $BL_R$ est préchargée à Vdd et les transistors d'accès $MA_L$ et $MA_R$ sont amenés à l'état conducteur. La tension de seuil du deuxième transistor de conduction $MD_R$ étant diminuée et la tension de seuil du premier transistor de conduction $MD_L$ étant augmentée, ceci facilite le passage à l'état passant du premier transistor de conduction $MD_L$ lors de la montée en tension du deuxième noeud de stockage $N_R$ et la fermeture du deuxième transistor de conduction $MD_R$ lors de la diminution de tension du premier noeud de stockage $N_L$. La stabilité en écriture de la cellule SRAM 270 est donc augmentée.

Dans les modes de réalisation décrits précédemment en relation avec les figures 10 à 12, la durée d'une opération d'écriture peut donc être réduite. Pour un circuit contenant une telle mémoire et dont la fréquence de fonctionnement est limitée par la durée d'une opération d'écriture dans la mémoire, ceci permet d'augmenter la fréquence de fonctionnement du circuit.

La figure 13 représente de façon partielle et schématique un mode de réalisation d'une mémoire SRAM comprenant plusieurs cellules mémoire. Dans le présent mode de réalisation, les cellules mémoire de la mémoire sont réalisées dans différents niveaux $Niv_1$ à $Niv_N$ d'un empilement de couches où N est un nombre entier, par exemple compris entre 2 et 128, le niveau $Niv_1$ étant le niveau à la base de l'empilement et le niveau $Niv_N$ étant le niveau au sommet de l'empilement. Chaque niveau peut comprendre des transistors MOS et des pistes métalliques d'au moins un niveau de métallisation. Le matériau conducteur électriquement composant les pistes métalliques du dernier niveau de métallisation peut être différent d'un niveau de l'empilement à l'autre. Le matériau isolant électriquement composant les couches isolantes sur lesquelles sont formées les pistes conductrices peut être différent d'un niveau de l'empilement à l'autre. Selon un mode de réalisation, pour le niveau $Niv_N$, les pistes métalliques du dernier niveau de métallisation sont en cuivre et pour les autres niveaux $Niv_1$ à $Niv_{N-1}$, les pistes métalliques du dernier niveau de métallisation sont en tungstène. Selon un mode de réalisation, pour le niveau $Niv_N$, le matériau isolant électriquement composant les couches isolantes est un matériau dit low-k et pour les autres niveaux $Niv_1$ à $Niv_{N-1}$, le matériau isolant électriquement composant les couches isolantes est du $SiO_2$. Un matériau low-k est un matériau dont la constante diélectrique est inférieure à 3,9. Il n'est en général pas possible de réaliser les pistes métalliques d'un niveau $Niv_1$ à $Niv_{N-1}$ en cuivre pour éviter les risques de pollution lors de la formation des couches conductrices d'un niveau supérieur.

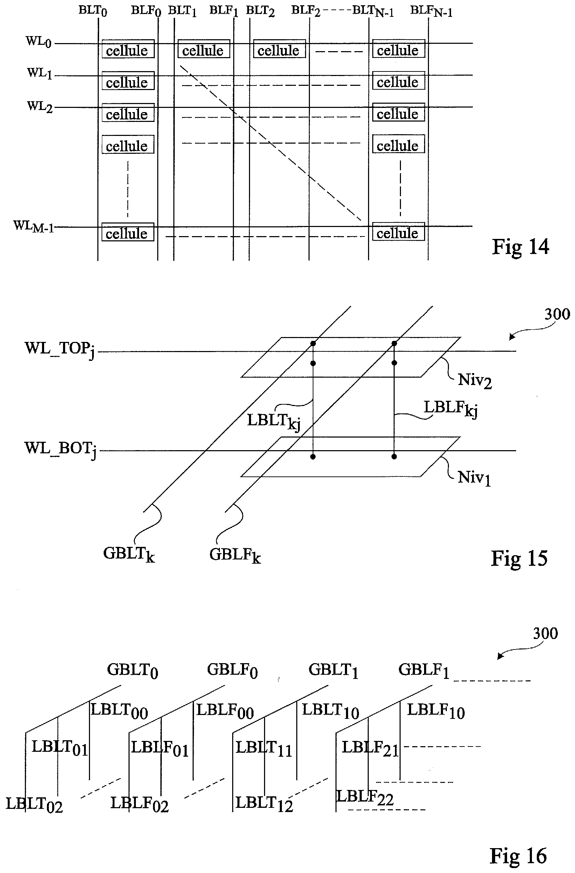

La figure 14 représente un schéma électrique d'un exemple d'une mémoire SRAM dans laquelle les cellules mémoire SRAM sont agencées en M rangées et en P colonnes où M et P sont des nombres entiers. La mémoire comprend, pour chaque rangée, une ligne de mot WLj, j étant un nombre entier variant entre 0 et M-1, qui est connectée à toutes les cellules mémoire de la rangée. La mémoire comprend, pour chaque colonne, deux lignes de bit $BL_{LK}$ et $BL_{RK}$, k étant un nombre entier variant entre 0 et P-1, qui sont connectées à toutes les cellules mémoire de la colonne.

Selon un mode de réalisation, il est prévu de réaliser les cellules mémoire de chaque colonne de la mémoire dans différents niveaux de l'empilement formant la mémoire.

Les figures 15 et 16 représentent un mode de réalisation d'une mémoire 300 sur deux niveaux $Niv_1$ et $Niv_2$ d'un empilement et dont le schéma électrique équivalent correspond au schéma représenté en figure 14. En figure 15, on a seulement représenté de façon très schématique deux cellules mémoire de la mémoire et sur la figure 16, on a seulement représenté les lignes de bit de la mémoire.

Dans le présent mode de réalisation, les cellules mémoire de la mémoire 300 sont reparties dans les deux niveaux $Niv_1$ et $Niv_2$. Les cellules mémoire du niveau supérieur $Niv_2$ sont agencées en M/2 rangées et en P colonnes. Pour chaque colonne de rang k, où k est un nombre entier variant de 0 à P-1, deux lignes de bit $GBLT_k$ et $GBLF_k$, formées par des pistes conductrices du niveau supérieur $Niv_2$, sont connectées aux cellules mémoire du niveau supérieur $Niv_2$ appartenant à la colonne considérée. Les cellules mémoire du niveau inférieur $Niv_1$ appartenant également à la colonne considérée sont connectées aux lignes de bit $GBLT_k$ et $GBLF_k$ par des interconnexions $LBLT_{k,j}$ et $LBLF_{k,j}$ qui relient les cellules mémoire du niveau inférieur $Niv_1$ à des pistes métalliques du niveau supérieur $Niv_2$.

Pour chaque rangée de rang j, où j est un nombre entier variant de 0 à M/2-1, une ligne de mot WL_TOPj, formée par une piste conductrice du niveau supérieur $Niv_2$, est connectée aux cellules mémoire du niveau supérieur $Niv_2$ appartenant à la rangée considérée et une ligne de mot WL_BOTj, formée par une piste conductrice du niveau inférieur $Niv_1$, est connectée aux cellules mémoire du niveau inférieur $Niv_1$ appartenant à la rangée considérée.

Le niveau $Niv_1$ (respectivement $Niv_2$) peut lui-même être divisé en un sous-niveau inférieur $N_{INF}$ et un sous-niveau supérieur $N_{SUP}$. Les transistors d'une cellule mémoire du niveau $Niv_1$ (respectivement $Niv_2$) peuvent alors être répartis sur les deux sous-niveaux $N_{INF}$ et $N_{SUP}$ selon l'une des structures décrites précédemment en relation avec les figures 5 à 12.

Bien que, dans le mode de réalisation de la mémoire 300 représentée sur les figures 15 et 16, les cellules mémoires soient réparties sur deux niveaux $Niv_1$ et $Niv_2$, il est clair que les cellules de la mémoire peuvent être réparties sur plus de deux niveaux.

Les pistes métalliques de la mémoire 300 les plus longues qui correspondent aux lignes de mot $GBLT_k$ et $GBLF_k$ sont, de façon avantageuse, formées dans le niveau supérieur $Niv_2$ et peuvent donc être formées dans un matériau qui est un bon conducteur électrique. A titre d'exemple, les lignes de bit $GBLT_k$ et $GBLF_k$ sont en cuivre et les interconnexions $LBLT_{k,j}$ et $LBLF_{k,j}$ sont en tungstène. Avec une telle organisation, l'accès aux cellules mémoire du niveau inférieur $N_{INF}$ n'est pas impacté par l'utilisation de tungstène dans les interconnections et du dioxyde de silicium $SiO_2$ pour le diélectrique des niveaux inférieurs.

Un avantage important de l'architecture réalisée sur au moins deux niveaux, en plus des gains de densité, est qu'elle permet de réduire significativement les longueurs des pistes conductrices formant les lignes de bit et des lignes de mot. En particulier, la longueur des lignes de bit $GBLT_k$ et $GBLF_k$ est réduite par rapport à une mémoire réalisée dans un seul niveau. La vitesse d'une opération d'écriture de la mémoire 300 représentée sur les figures 14 et 15 peut ainsi être augmentée.

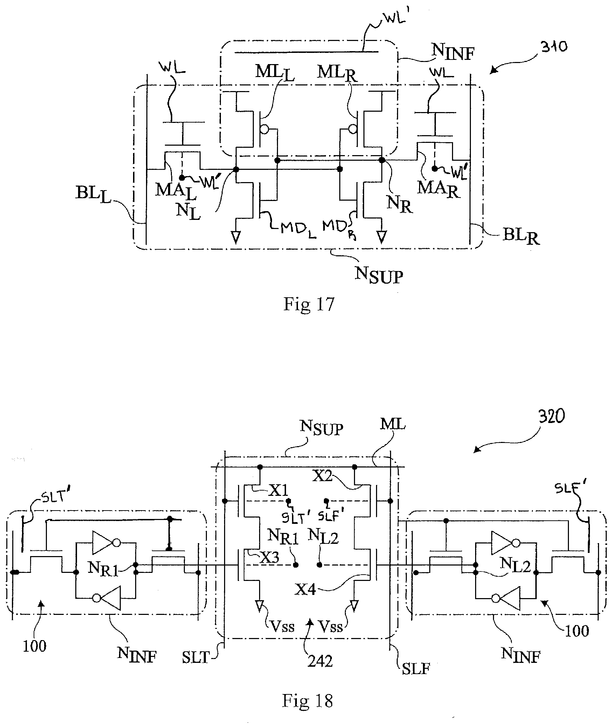

La figure 17 illustre un mode de réalisation d'une cellule mémoire SRAM 310 à six transistors dont les transistors sont répartis sur deux niveaux $N_{INF}$ et $N_{SUP}$ et dans laquelle un procédé d'assistance en lecture est mis en oeuvre. La cellule mémoire SRAM 310 comprend l'ensemble des éléments de la cellule mémoire 100 représentée en figure 4. Les transistors MOS à canal N $MA_L$, $MA_R$, $MD_L$ et $MD_R$ sont situés dans le niveau supérieur $N_{SUP}$ et les transistors MOS à canal P $ML_L$ et $ML_R$ sont situés dans le niveau inférieur $N_{INF}$. Dans le présent mode de réalisation, une ligne de mots supplémentaire WL' est prévue dans le niveau inférieur $N_{INF}$ et reçoit la même tension que celle appliquée sur la ligne de mots WL. Les zones de canal des premier et deuxième transistors d'accès $MA_L$ et $MA_R$ sont couplées à la ligne de mots supplémentaire WL', ce qui est représenté de façon schématique en figure 17 par des traits pointillés.

Le présent mode de réalisation permet d'augmenter la tension de seuil des transistors d'accès $MA_L$ et $MA_R$ lorsque la ligne de mots WL' est à '0' et de diminuer la tension de seuil des transistors d'accès $MA_L$ et $MA_R$ lorsque la ligne de mots WL' est à '1'.

La figure 18 illustre un mode de réalisation d'une cellule mémoire SRAM 320 d'une mémoire adressable par contenu dont les transistors sont répartis sur deux niveaux $N_{INF}$ et $N_{SUP}$ et dans laquelle un procédé d'assistance en lecture est mis en oeuvre. La cellule mémoire SRAM 320 comprend l'ensemble des éléments de la cellule mémoire 240 représentée en figure 9 à la différence qu'une ligne de bit de lecture supplémentaire SLT' est prévue dans le niveau inférieur $N_{INF}$ et reçoit la même tension que celle appliquée sur la ligne de bit de lecture SLT, qu'une ligne de bit de lecture supplémentaire SLF' est prévue dans le niveau inférieur $N_{INF}$ et reçoit la même tension que celle appliquée sur la ligne de bit de lecture SLF, que la zone de canal du transistor X1 est couplée à la ligne de bit de lecture SLT' et que la zone de canal du transistor X2 est couplée ou connectée à la ligne de bit de lecture SLF'.

La zone de canal du transistor X3 peut être couplée ou connectée comme cela est représenté en figure 9 ou peut, à titre de variante, être couplée à la ligne de bit de lecture SLT'. La zone de canal du transistor X4 peut être couplée comme cela est représenté en figure 9 ou peut, à titre de variante, être couplée à la ligne de bit de lecture SLF'.

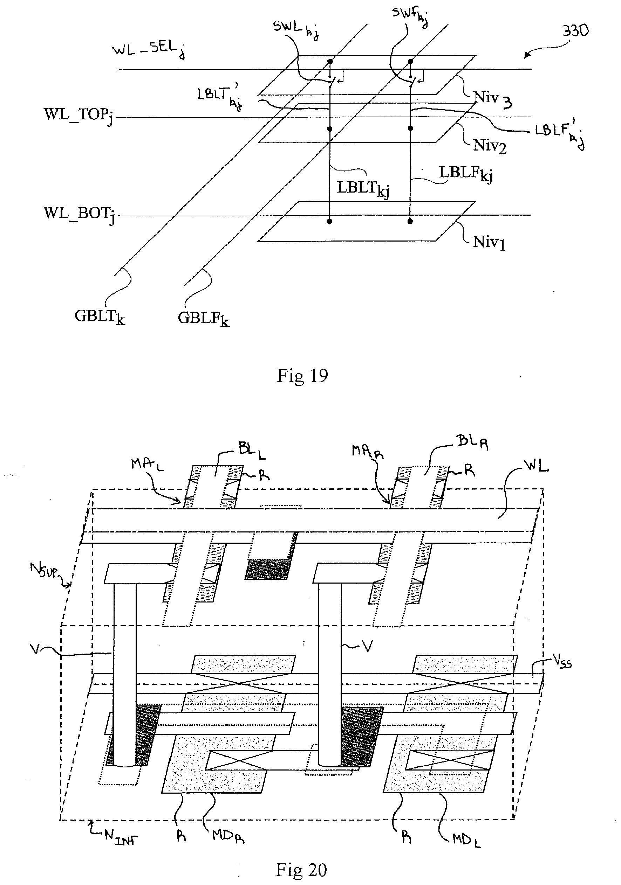

La figure 19 est un schéma analogue à la figure 15 illustrant un autre mode de réalisation d'une mémoire SRAM 330 sur deux niveaux. La mémoire 330 comprend l'ensemble des éléments de mémoire 300 représentés sur les figures 15 et 16 et comprend en outre un niveau supplémentaire $Niv_3$ dans lequel sont prévues les deux lignes de bit $GBLT_k$ et $GBLF_k$, un interrupteur $SWT_{kj}$ relié à la ligne de bit $GBLT_k$ et un interrupteur $SWF_{kj}$ relié à la ligne de bit $GBLF_k$, les cellules mémoire du niveau inférieur $Niv_2$ appartenant également à la colonne considérée sont respectivement connectées aux interrupteurs $SWT_{kj}$ et $SWT_{kj}$ par des interconnexions $LBLT'_{kj}$ et $LBLF'_{kj}$. Les cellules mémoire des niveaux inférieurs $Niv_1$ et $Niv_2$ appartenant à la colonne considérée sont donc connectées aux lignes de bit $GBLT_k$ et $GBLF_k$ par les interconnexions $LBLT_{k, j}$, $LBLF_{kj}$, $LBLT'_{kj}$, $LBLF'_{kj}$ qui relient les cellules mémoire des niveaux inférieurs $Niv_1$ et $Niv_2$ aux interrupteurs SWTkj et SWFkj du niveau supérieur $Niv_3$. Les interrupteurs SWTkj et SWFkj sont commandés par une ligne de sélection $WL\_SEL_j$. Ceci permet d'isoler les cellules des lignes de bit $GBLT_k$ et $GBLF_k$ lors d'opérations de lecture et/ou d'écriture.

La figure 20 est une vue en perspective, partielle et schématique, d'un mode de réalisation de la cellule mémoire SRAM de la figure 7 sur deux niveaux $N_{INF}$ et $N_{SUP}$. Toutefois, en figure 20, les couplages des zones de canal des transistors $MA_L$ et $MA_R$ ne sont pas représentées. Pour chaque niveau $N_{INF}$ et $N_{SUP}$, les régions R correspondent à des régions semiconductrices actives, les pistes en traits pleins correspondent à des pistes conductrices formées directement sur les régions actives, les pistes en traits pointillés correspondent à des pistes conductrices d'un premier niveau de métallisation et la piste en traits mixtes correspond à une piste conductrice d'un deuxième niveau de métallisation. Les éléments V sont des vias conducteurs connectant des éléments du niveau $N_{INF}$ à des éléments du niveau $N_{SUP}$.

## Revendications

1. Mémoire vive statique à accès aléatoire comprenant des cellules (200 ; 210 ; 220 ; 230 ; 240 ; 250 ; 260 ; 270) de mémoire vive statique à accès aléatoire agencées en rangées et en colonnes, des pistes conductrices électriquement (WL, WL', $BL_L$, $BL_R$) s'étendant selon les rangées et les colonnes dont des lignes de mots, des premières lignes de bits ($BL_L$) et des deuxièmes lignes de bit ($BL_R$) et un circuit de fourniture de signaux d'amplitudes variables sur les pistes conductrices, chaque cellule mémoire comprenant dans un empilement (25) de couches, des transistors dont au moins des premier et deuxième transistors d'accès ($MA_L$, $MA_R$) connectés à l'une des lignes de mot (WL), le premier transistor d'accès ($MA_L$) reliant l'une des premières lignes de bit ($BL_L$) et un premier noeud de stockage ($N_L$) et le deuxième transistor d'accès ($MA_R$) reliant l'une des deuxièmes lignes de bit ($BL_R$) et un deuxième noeud de stockage ($N_R$), et une bascule comprenant un premier transistor de conduction ($MD_L$, $MR_L$) reliant le premier noeud de stockage à une source d'un premier potentiel de référence (Vdd, Vss) et dont la grille est reliée au deuxième noeud de stockage et un deuxième transistor de conduction ($MD_R$, $MR_R$) reliant le deuxième noeud de stockage à la source du premier potentiel de référence et dont la grille est reliée au premier noeud de stockage, les transistors se répartissant en une première pluralité de transistors situés à un premier niveau ($N_{SUP}$) de l'empilement et une deuxième pluralité de transistors situés à au moins un deuxième niveau ($N_{INF}$) de l'empilement, **caractérisé en ce que** la cellule mémoire comprend une portion conductrice électriquement (60) du deuxième niveau connectée à un noeud interne de la cellule mémoire ou à l'une des lignes de mots, des premières lignes de bits et des deuxièmes lignes de bits et située en regard d'une zone de canal (56) d'un transistor de la première pluralité de transistors et séparée de ladite zone de canal par l'intermédiaire d'une zone isolante (62) prévue ou connectée électriquement à une portion semiconductrice (50) contenant ladite zone de canal pour permettre un couplage entre la portion conductrice électriquement et ladite zone de canal, ledit noeud interne correspondant à l'un ou l'autre des premier et deuxième noeuds de stockage.

**2.** Mémoire selon la revendication 1, dans laquelle, pour chaque cellule mémoire, la portion conductrice électriquement (60) est connectée à un élément choisi parmi le premier noeud de stockage ($N_L$), le deuxième noeud de stockage ($N_R$), la première ligne de bit ($BL_L$), la deuxième ligne de bit ($BL_R$) et l'une des pistes conductrices (WL') qui est commandée comme la ligne de mot (WL).

**3.** Mémoire selon la revendication 2, dans laquelle, pour chaque cellule mémoire, la portion conductrice électriquement (60) est connectée à l'un du premier noeud de stockage ($N_L$) ou du deuxième noeud de stockage ($N_R$).

**4.** Mémoire selon la revendication 2 ou 3, dans laquelle, pour chaque cellule mémoire, la bascule comprend en outre un troisième transistor de conduction ($MD_L$, $MR_L$) reliant le premier noeud de stockage ($N_L$) à une source d'un deuxième potentiel de référence (Vdd ; Vss) et dont la grille est reliée au deuxième noeud de stockage ($N_R$) et un quatrième transistor de conduction ($MD_R$, $MR_R$) reliant le deuxième noeud de stockage à la source du deuxième potentiel de référence et dont la grille est reliée au premier noeud de stockage ($N_L$).

**5.** Mémoire selon la revendication 4, dans laquelle, pour chaque cellule mémoire, les premier et deuxième transistors d'accès ($MA_L$, $MA_R$) et les premier et deuxième transistors de conduction ($MD_L$, $MD_R$) sont situés dans le deuxième niveau ($N_{INF}$), dans laquelle les troisième et quatrième transistors de conduction ($ML_L$, $ML_R$) sont situés dans le premier niveau ($N_{SUP}$), dans laquelle la zone de canal du troisième transistor de conduction ($ML_L$) est couplée au deuxième noeud de stockage ($N_R$) et dans laquelle la zone de canal du quatrième transistor de conduction ($ML_R$) est couplée au premier noeud de stockage ($N_L$).

**6.** Mémoire selon la revendication 4, dans laquelle, pour chaque cellule mémoire, les premier et deuxième transistors d'accès ($MA_L$, $MA_R$) et les premier et deuxième transistors de conduction ($MD_L$, $MD_R$) sont situés dans le premier niveau ($N_{SUP}$), dans laquelle les troisième et quatrième transistors de conduction ($ML_L$, $ML_R$) sont situés dans le deuxième niveau ($N_{INF}$), dans laquelle la zone de canal du premier transistor d'accès ($MA_L$) et/ou la zone de canal du deuxième transistor d'accès ($MA_R$) est couplée à ladite piste conductrice (WL') commandée comme la ligne de mot (WL).

**7.** Mémoire selon la revendication 2 ou 3, dans laquelle, pour chaque cellule mémoire, les premier et deuxième transistors d'accès ($MA_L$, $MA_R$) sont situés dans le premier niveau ($N_{SUP}$), dans laquelle les premier et deuxième transistors de conduction ($ML_L$, $ML_R$ ; $MD_L$, $MD_R$) sont situés dans le deuxième niveau ($N_{INF}$), dans laquelle la zone de canal du premier transistor d'accès ($MA_L$) est couplée au deuxième noeud de stockage ($N_R$) et dans laquelle la zone de canal du deuxième transistor d'accès ($MA_R$) est couplée au premier noeud de stockage ($N_L$).

**8.** Mémoire selon l'une quelconque des revendications 1 à 5, comprenant en outre, pour au moins l'une des cellules mémoire, un circuit de lecture (232 ; 242) comprenant des premier et deuxième transistors de lecture (RPPG, RPPD ; X2, X4), le premier noeud de stockage ($N_L$) de ladite cellule étant connecté à la grille du deuxième transistor de lecture (RPPD ; X4), le premier transistor de lecture (RPPG ; X2) reliant le deuxième transistor de lecture (RPPD ; X4) à une première ligne de bit de lecture (RBL ; ML), la grille du deuxième transistor de lecture (RPPG ; X2) étant connectée à une deuxième ligne de bit de lecture (RWL ; SLF), dans laquelle les premier et deuxième transistors de lecture (RPPG, RPPD ; X2, X4) sont situés dans le premier niveau ($N_{SUP}$), et dans laquelle les premier et deuxième transistors d'accès ($MA_L$, $MA_R$) et les premier et deuxième transistors de conduction ($ML_L$, $ML_R$ ; $MD_L$, $MD_R$) de ladite cellule sont situés dans le deuxième niveau ($N_{INF}$).

**9.** Mémoire selon la revendication 8, dans laquelle la zone de canal du premier transistor de lecture (RPPG ; X2) est couplée au premier noeud de stockage ($N_L$ ; $N_{L2}$) et dans laquelle la zone de canal du deuxième transistor de lecture (RPPD ; X4) est couplée au premier noeud de stockage ($N_L$ ; $N_{L2}$).

**10.** Mémoire selon la revendication 8, dans laquelle la zone de canal du premier transistor de lecture (X2) est couplée à l'une des pistes conductrices (SLF') qui est commandée comme la deuxième ligne de bit de lecture (SLF).

**11.** Mémoire selon la revendication 2, dans laquelle, pour chaque cellule mémoire, la portion conductrice électriquement (60) est connectée à l'une de la première ligne de bit ($BL_L$) ou de la deuxième ligne de bit ($BL_R$).

**12.** Mémoire selon la revendication 2 ou 11, dans laquelle, pour chaque cellule mémoire, les premier et deuxième transistors d'accès ($MA_L$, $MA_R$) sont situés dans le deuxième niveau ($N_{INF}$), dans laquelle les premier et deuxième transistors de conduction ($ML_L$, $ML_R$ ; $MD_L$, $MD_R$) sont situés dans le premier niveau ($N_{SUP}$), dans laquelle la zone de canal du premier transistor de conduction ($ML_L$ ; $MD_L$) est couplée à la deuxième ligne de bit ($BL_R$) et dans laquelle la zone de canal du deuxième transistor de conduction (ML$_R$ ; MD$_R$) est couplée à la première ligne de bit (BL$_L$) .

13. Mémoire selon la revendication 12 dans son rattachement à la revendication 4, dans laquelle, pour chaque cellule mémoire, les troisième et quatrième transistors de conduction (MD$_L$, MD$_R$) sont situés dans le deuxième niveau (N$_{INF}$).

14. Mémoire selon l'une quelconque des revendications 1 à 13, dans laquelle les cellules mémoire comprennent des premières cellules réparties dans une première partie (Niv$_1$) de l'empilement et des deuxièmes cellules réparties dans une deuxième partie (Niv$_2$) de l'empilement, les premières cellules formant au moins une colonne, la mémoire comportant une première piste conductrice électriquement (GBLT$_k$) s'étendant le long de la colonne et formant la première ligne de bit de chaque première cellule et une seconde piste conductrice électriquement (GBLF$_k$) s'étendant le long de la colonne et formant la deuxième ligne de bit de chaque première cellule, la mémoire comportant, en outre, des éléments d'interconnexion (LBLT$_{kj}$, LBLF$_{kj}$) s'étendant au travers des couches de l'empilement et reliant chaque deuxième cellule mémoire aux première et deuxième pistes.

15. Mémoire selon la revendication 14, dans laquelle les première et deuxième pistes conductrices (GBLT$_k$, GBLF$_k$) sont en un premier matériau et dans laquelle les éléments d'interconnexion (LBLT$_{kj}$, LBLF$_{kj}$) sont en un deuxième matériau moins bon conducteur électrique que le premier matériau.


## Patentansprüche

1. Ein SRAM, aufweisend SRAM Zellen (200; 210; 220; 230; 240; 250; 260; 270) angeordnet in Zeilen und Spalten, elektrisch leitende Spuren (WL, WL', BL$_L$, BL$_R$), die sich entlang der Zeilen und der Spalten erstrecken mit Wortleitungen, ersten Bitleitungen (BL$_L$), und zweiten Bitleitungen (BL$_R$) und ein Schaltkreis um Signale mit variablen Amplituden auf den leitenden Spuren zu liefern, jede Speicherzelle aufweisend in einem Stack (25) von Schichten Transistoren mit wenigstens ersten und zweiten Zugriffstransistoren (MA$_L$, MA$_R$) verbunden mit einer der Wortleitungen (WL), wobei der erste Zugriffstransistor (MA$_L$) eine der ersten Bitleitungen (BL$_L$) und einen ersten Speicherknoten (N$_L$) koppelt und der zweite Zugriffstransistor (MA$_R$) eine der zweiten Bitleitungen (BL$_R$) und einen zweiten Speicherknoten (N$_R$) koppelt, und einen Flip-Flop aufweisend einen ersten Leitungstransistor (MD$_L$, MR$_L$), der den ersten Speicherknoten mit einer Quelle mit einem ersten Referenzpotential (Vdd, Vss) koppelt und dessen Gate mit dem zweiten Speicherknoten gekoppelt ist, und einen zweiten Leitungstransistor (MD$_R$, MR$_R$), der den zweiten Speicherknoten mit der Quelle mit dem ersten Referenzpotential koppelt und dessen Gate mit dem ersten Speicherknoten gekoppelt ist, wobei die Transistoren verteilt sind in eine erste Vielzahl von Transistoren, die sich in einer ersten Schicht (N$_{SUP}$) des Stacks befinden und eine zweite Vielzahl von Transistoren, die sich in wenigstens einer zweiten Schicht (N$_{INF}$) des Stacks befinden, **gekennzeichnet dadurch dass** die Speicherzelle einen elektrisch leitenden Bereich (60) der zweiten Schicht aufweist, verbunden mit einem inneren Knoten der Speicherzelle oder mit einer der Wortleitungen, ersten Bitleitungen, und zweiten Bitleitungen und der sich gegenüber eines Kanalbereichs (56) eines Transistors der ersten Vielzahl von Transistoren befindet und getrennt von dem Kanalbereich über einen isolierenden Bereich (62) bereitgestellt ist, oder elektrisch verbunden mit einem Halbleiterbereich (50), der den Kanalbereich enthält, um eine Kopplung zwischen dem elektrisch leitenden Bereich und dem Kanalbereich zu ermöglichen, wobei der innere Knoten einem oder dem anderen der ersten und zweiten Speicherknoten entspricht.

2. Der Speicher nach Anspruch 1, wobei, für jede Speicherzelle, der elektrisch leitende Bereich (60) mit einem Element verbunden ist, ausgewählt aus dem ersten Speicherknoten (N$_L$), dem zweiten Speicherknoten (N$_R$), der ersten Bitleitung (BL$_L$), der zweiten Bitleitung (BL$_R$), und einer der leitenden Spuren (WL'), die wie die Wortleitung (WL) gesteuert wird.

3. Der Speicher nach Anspruch 2, wobei, für jede Speicherzelle, der elektrisch leitende Bereich (60) mit einem verbunden ist aus dem ersten Speicherkoten (N$_L$) oder dem zweiten Speicherknoten (N$_R$).

4. Der Speicher nach Anspruch 2 oder 3, wobei, für jede Speicherzelle, der Flip-Flop ferner einen dritten Bereich Leitungstransistor (MD$_L$, MR$_L$) aufweist, der den ersten Speicherknoten (N$_L$) mit einer Quelle mit einem zweiten Referenzpotential (Vdd; Vss) koppelt und dessen Gate mit dem zweiten Speicherknoten (N$_R$) gekoppelt ist und einen vierten Leitungstransistor (MD$_R$, MR$_R$), der den zweiten Speicherknoten mit der Quelle mit dem zweiten Referenzpotential koppelt und dessen Gate mit dem ersten Speicherknoten (N$_L$) gekoppelt ist.

5. Der Speicher nach Anspruch 4, wobei sich, für jede Speicherzelle, die ersten und zweiten Zugriffstransistoren ($MA_L$, $MA_R$) und die ersten und zweiten Leitungstransistoren ($MD_L$, $MD_R$) in der zweiten Schicht ($N_{INF}$) befinden, wobei dich der dritte und vierte Leitungstransistor ($ML_L$, $ML_R$) in der ersten Schicht ($N_{SUP}$) befinden, wobei der Kanalbereich des dritten Leitungstransistors ($ML_L$) mit dem zweiten Speicherknoten ($N_R$) gekoppelt ist, und wobei der Kanalbereich des vierten Leitungstransistors ($ML_R$) mit dem ersten Speicherknoten ($N_L$) gekoppelt ist.

6. Der Speicher nach Anspruch 4, wobei sich, für jede Speicherzelle, die ersten und zweiten Zugriffstransistoren ($MA_L$, $MA_R$) und die ersten und zweiten Leitungstransistoren ($MD_L$, $MD_R$) in der ersten Schicht ($N_{SUP}$) befinden, wobei sich der dritte und vierte Leitungstransistor ($ML_L$, $ML_R$) in der zweiten Schicht ($N_{INF}$) befinden, wobei der Kanalbereich des ersten Zugriffstransistors ($MA_L$) und/ oder der Kanalbereich des zweiten Zugriffstransistors ($MA_R$) mit der leitenden Spur (WL') gekoppelt ist, die wie die Wortleitung (WL) gesteuert wird.

7. Der Speicher nach Anspruch 2 oder 3, wobei sich, für jede Speicherzelle, die ersten und zweiten Zugriffstransistoren ($MA_L$, $MA_R$) in der ersten Schicht ($N_{SUP}$) befinden, wobei sich die ersten und zweiten Leitungstransistoren ($ML_L$, $ML_R$; $MD_L$, $MD_R$) in der zweiten Schicht ($N_{INF}$) befinden, wobei der Kanalbereich des ersten Zugriffstransistors ($MA_L$) mit dem zweiten Speicherknoten ($N_R$) gekoppelt ist, und wobei der Kanalbereich des zweiten Zugriffstransistors ($MA_R$) mit dem ersten Speicherknoten ($N_L$) gekoppelt ist.

8. Der Speicher nach einem der Ansprüche 1 bis 5, ferner aufweisend, für wenigstens eine der Speicherzellen, einen Ausleseschaltkreis (232; 242) aufweisend erste und zweite Auslesetransistoren (RPPG, RPPD; X2, X4), wobei der erste Speicherknoten ($N_L$) der Zelle mit dem Gate des zweiten Auslesetransistors (RPPD; X4) verbunden ist, wobei der erste Auslesetransistor (RPPG; X2) den zweiten Auslesetransistor (RPPD; X4) mit einer ersten Lese-Bitleitung (RBL; ML) koppelt, wobei das Gate des zweiten Auslesetransistors (RPPG; X2) mit einer zweiten Lese-Bitleitung (RWL; SLF) verbunden ist, wobei sich die ersten und zweiten Auslesetransistoren (RPPG, RPPD; X2, X4) in der ersten Schicht ($N_{SUP}$) befinden, und wobei sich die ersten und zweiten Zugriffstransistoren ($MA_L$, $MA_R$) und die ersten und zweiten Leitungstransistoren ($ML_L$, $ML_R$; $MD_L$, $MD_R$) der Zelle in der zweiten Schicht ($N_{INF}$) befinden.

9. Der Speicher nach Anspruch 8, wobei der Kanalbereich des ersten Auslesetransistors (RPPG; X2) mit dem ersten Speicherknoten ($N_L$; $N_{L2}$) gekoppelt ist und wobei der Kanalbereich des zweiten Auslesetransistors (RPPD; X4) mit dem ersten Speicherknoten ($N_L$; $N_{L2}$) gekoppelt ist.

10. Der Speicher nach Anspruch 8, wobei der Kanalbereich des ersten Auslesetransistors (X2) mit einer der leitenden Spuren (SLF') gekoppelt ist, die wie die zweite Lese-Bitleitung (SLF) gesteuert wird.

11. Der Speicher nach Anspruch 2, wobei, für jede Speicherzelle, der elektrisch leitende Bereich (60) mit einem verbunden ist aus der ersten Bitleitung ($BL_L$) oder der zweiten Bitleitung ($BL_R$).

12. Der Speicher nach Anspruch 2 oder 11, wobei sich, für jede Speicherzelle, die ersten und zweiten Zugriffstransistoren ($MA_L$, $MA_R$) in der zweiten Schicht ($N_{INF}$) befinden, wobei sich die ersten und zweiten Leitungstransistoren ($ML_L$, $ML_R$; $MD_L$, $MD_R$) in der ersten Schicht ($N_{SUP}$) befinden, wobei der Kanalbereich des ersten Leitungstransistors ($ML_L$; $MD_L$) mit der zweiten Bitleitung ($BL_R$) gekoppelt ist, und wobei der Kanalbereich des zweiten Leitungstransistors ($ML_R$; $MD_R$) mit der ersten Bitleitung ($BL_L$) gekoppelt ist.

13. Der Speicher nach Anspruch 12 und Anspruch 4, wobei sich, für jede Speicherzelle, die dritten und vierten Leitungstransistoren ($MD_L$, $MD_R$) in der zweiten Schicht ($N_{INF}$) befinden.

14. Der Speicher nach einem der Ansprüche 1 bis 13, wobei die Speicherzellen erste Zellen aufweisen, die in einem ersten Bereich ($Niv_1$) des Stacks verteilt sind und zweite Zellen, die in einem zweiten Bereich ($Niv_2$) des Stacks verteilt sind, wobei die ersten Zellen wenigstens eine Spalte bilden, der Speicher aufweisend eine erste elektrisch leitende Spur ($GBLT_k$), die sich entlang der Spalte erstreckt und die erste Bitleitung jeder ersten Zelle bildet und eine zweite elektrisch leitende Spur ($GBLF_k$), die sich entlang der Spalte erstreckt und die zweite Bitleitung jeder ersten Zelle bildet, der Speicher ferner aufweisend Verbindungselemente ($LBLT_{kj}$; $LBLF_{kj}$), die sich durch die Schichten des Stacks erstrecken und jede zweite Speicherzelle mit den ersten und zweiten Spuren koppeln.

15. Der Speicher nach Anspruch 14, wobei die ersten und zweiten leitenden Spuren ($GBLT_k$, $GBLF_k$) aus einem ersten Material gefertigt sind und wobei die Verbindungselemente ($LBLT_{kj}$, $LBLF_{kj}$) aus einem zweiten Material gefertigt sind mit schlechterer elektrischer Leitfähigkeit als das erste Material.

**Claims**

1.  A SRAM, comprising SRAM cells (200; 210; 220; 230; 240; 250; 260; 270) arranged in rows and in columns, electrically-conductive tracks (WL, WL', $BL_L$, $BL_R$) extending along the rows and the columns including word lines, first bit lines ($BL_L$), and second bit lines ($BL_R$) and a circuit for providing signals of variable amplitudes on the conductive tracks, each memory cell comprising in a stack (25) of layers transistors including at least first and second access transistors ($MA_L$, $MA_R$) connected to one of the word lines (WL), the first access transistor ($MA_L$) coupling one of the first bit lines ($BL_L$) and a first storage node ($N_L$) and the second access transistor ($MA_R$) coupling one of the second bit lines ($BL_R$) and a second storage node ($N_R$), and a flip-flop comprising a first conduction transistor ($MD_L$, $MR_L$) coupling the first storage node to a source of a first reference potential (Vdd, Vss) and having its gate coupled to the second storage node and a second conduction transistor ($MD_R$, $MR_R$) coupling the second storage node to the source of the first reference potential and having its gate coupled to the first storage node, the transistors being distributed into a first plurality of transistors located at a first level ($N_{SUP}$) of the stack and a second plurality of transistors located at least a second level ($N_{INF}$) of the stack, **characterized in that** the memory cell comprises an electrically-conductive portion (60) of the second level connected to an inner node of the memory cell or to one of the word lines, first bit lines, and second bit lines and located opposite a channel area (56) of a transistor of the first plurality of transistors and separated from said channel area via an insulating area (62) provided or electrically-connected to a semiconductor portion (50) containing said channel area to allow a coupling between the electrically-conductive portion and said channel area, said inner node corresponding to one or the other of the first and second storage nodes.

2.  The memory of claim 1, wherein, for each memory cell, the electrically-conductive portion (60) is connected to an element selected from among the first storage node ($N_L$), the second storage node ($N_R$), the first bit line ($BL_L$), the second bit line ($BL_R$), and one of the conductive tracks (WL') that is controlled like the word line (WL).

3.  The memory of claim 2, wherein, for each memory cell, the electrically-conductive portion (60) is connected to one of the first storage node ($N_L$) or of the second storage node ($N_R$).

4.  The memory of claim 2 or 3, wherein, for each memory cell, the flip-flop further comprises a third conduction transistor ($MD_L$, $MR_L$) coupling the first storage node ($N_L$) to a source of a second reference potential (Vdd; Vss) and having its gate coupled to the second storage node ($N_R$) and a fourth conduction transistor ($MD_R$, $MR_R$) coupling the second storage node to the source of the second reference potential and having its gate coupled to the first storage node ($N_L$).

5.  The memory of claim 4, wherein, for each memory cell, the first and second access transistors ($MA_L$, $MA_R$) and the first and second conduction transistors ($MD_L$, $MD_R$) are located in the second level ($N_{INF}$), wherein the third and fourth conduction transistors ($ML_L$, $ML_R$) are located in the first level ($N_{SUP}$), wherein the channel area of the third conduction transistor ($ML_L$) is coupled to the second storage node ($N_R$), and wherein the channel area of the fourth conduction transistor ($ML_R$) is coupled to the first storage node ($N_L$).

6.  The memory of claim 4, wherein, for each memory cell, the first and second access transistors ($MA_L$, $MA_R$) and the first and second conduction transistors ($MD_L$, $MD_R$) are located in the first level ($N_{SUP}$), wherein the third and fourth conduction transistors ($ML_L$, $ML_R$) are located in the second level ($N_{INF}$), wherein the channel area of the first access transistor ($MA_L$) and/or the channel area of the second access transistor ($MA_R$) is coupled to said conductive track (WL') controlled like the word line (WL).

7.  The memory of claim 2 or 3, wherein, for each memory cell, the first and second access transistors ($MA_L$, $MA_R$) are located in the first level ($N_{SUP}$), wherein the first and second conduction transistors ($ML_L$, $ML_R$; $MD_L$, $MD_R$) are located in the second level ($N_{INF}$), wherein the channel area of the first access transistor ($MA_L$) is coupled to the second storage node ($N_R$), and wherein the channel area of the second access transistor ($MA_R$) is coupled to the first storage node ($N_L$).

8.  The memory of any of claims 1 to 5, further comprising, for at least one of the memory cells, a readout circuit (232; 242) comprising first and second readout transistors (RPPG, RPPD; X2, X4), the first storage node ($N_L$) of said cell being connected to the gate of the second readout transistor (RPPD; X4), the first readout transistor (RPPG; X2) coupling the second readout transistor (RPPD; X4) to a first read bit line (RBL; ML), the gate of the second readout transistor (RPPG; X2) being connected to a second read bit line (RWL; SLF), wherein the first and second readout transistors (RPPG, RPPD; X2, X4) are located in the first level ($N_{SUP}$), and wherein the first and second access transistors ($MA_L$, $MA_R$) and the first and second conduction transistors ($ML_L$, $ML_R$; $MD_L$, $MD_R$) of said cell are located in the second level ($N_{INF}$).

9. The memory of claim 8, wherein the channel area of the first readout transistor (RPPG; X2) is coupled to the first storage node ($N_L$; $N_{L2}$) and wherein the channel area of the second readout transistor (RPPD; X4) is coupled to the first storage node ($N_L$; $N_{L2}$).

10. The memory of claim 8, wherein the channel area of the first readout transistor (X2) is coupled to one of the conductive tracks (SLF') that is controlled like the second read bit line (SLF).

11. The memory of claim 2, wherein, for each memory cell, the electrically-conductive portion (60) is connected to one of the first bit line ($BL_L$) or of the second bit line ($BL_R$).

12. The memory of claim 2 or 11, wherein, for each memory cell, the first and second access transistors ($MA_L$, $MA_R$) are located in the second level ($N_{INF}$), wherein the first and second conduction transistors ($ML_L$, $ML_R$; $MD_L$, $MD_R$) are located in the first level ($N_{SUP}$), wherein the channel area of the first conduction transistor ($ML_L$; $MD_L$) is coupled to the second bit line ($BL_R$), and wherein the channel area of the second conduction transistor ($ML_R$; $MD_R$) is coupled to the first bit line ($BL_L$).

13. The memory of claim 12 and of claim 4, wherein, for each memory cell, the third and fourth conduction transistors ($MD_L$, $MD_R$) are located in the second level ($N_{INF}$).

14. The memory of any of claims 1 to 13, wherein the memory cells comprise first cells distributed in a first portion ($Niv_1$) of the stack and second cells distributed in a second portion ($Niv_2$) of the stack, the first cells forming at least one column, the memory comprising a first electrically-conductive track ($GBLT_k$) extending along the column and forming the first bit line of each first cell and a second electrically-conductive track ($GBLF_k$) extending along the column and forming the second bit line of each first cell, the memory further comprising interconnection elements ($LBLT_{kj}$, $LBLF_{kj}$) extending through the layers of the stack and coupling each second memory cell to the first and second tracks.

15. The memory of claim 14, wherein the first and second conductive tracks ($GBLT_k$, $GBLF_k$) are made of a first material and wherein the interconnection elements ($LBLT_{kj}$, $LBLF_{kj}$) are made of a second material having a poorer electric conductivity than the first material.

Fig 1

Fig 2

FIG 3A

FIG 3B

Fig 4

Fig 5

Fig 6

Fig 7

Fig 8

Fig 9

Fig 10

Fig 11

Fig 12

Fig 13

BLT$_0$   BLF$_0$  BLT$_1$  BLF$_1$  BLT$_2$  BLF$_2$----BLT$_{N-1}$  BLF$_{N-1}$

WL$_0$ — cellule   cellule   cellule   ----   cellule

WL$_1$ — cellule   ----   cellule

WL$_2$ — cellule   cellule

cellule   cellule

WL$_{M-1}$ — cellule   cellule

**Fig 14**

300

WL_TOP$_j$

Niv$_2$

LBLF$_{kj}$

LBLT$_{kj}$

WL_BOT$_j$

Niv$_1$

GBLT$_k$     GBLF$_k$

**Fig 15**

300

GBLT$_0$        GBLF$_0$        GBLT$_1$        GBLF$_1$

LBLT$_{00}$       LBLF$_{00}$      LBLT$_{10}$       LBLF$_{10}$

LBLT$_{01}$      LBLF$_{01}$      LBLT$_{11}$       LBLF$_{21}$

LBLT$_{02}$     LBLF$_{02}$      LBLT$_{12}$      LBLF$_{22}$

**Fig 16**

Fig 17

Fig 18

SWL$_{kj}$  SWF$_{kj}$

WL_SEL$_j$

330

LBLT$'_{kj}$

Niv$_3$

WL_TOP$_j$

LBLF$'_{kj}$

Niv$_2$

LBLF$_{kj}$

LBLT$_{kj}$

WL_BOT$_j$

Niv$_1$

GBLT$_k$   GBLF$_k$

Fig 19

MA$_L$   BL$_L$   MA$_R$   BL$_R$   WL

R   R

N$_{SUP}$

V   V   V$_{SS}$

N$_{INT}$   R   MD$_R$   R   MD$_L$

Fig 20

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2014185085 A1

**Littérature non-brevet citée dans la description**

- **LIM ; FOSSUM.** *IEEE Transactions on electron de-vices,* Octobre 1983, vol. ED-30 (10